# EUROPEAN PATENT APPLICATION

(11) **EP 4 509 955 A1**
(43) Date of publication of application: **19.02.2025**
(21) Application number: 24184734.2
(22) Date of filing: 26.06.2024
(51) Int. Cl.: G06F 1/20, H01L 23/40

(54) **BACKSIDE INTEGRATED TORSION LOADING MECHANISM**

(30) Priority: 16.08.2023 US 202318450928
(71) Applicant: Intel Corporation, Santa Clara, CA 95054 (US)
(72) Inventor: SHIA, David, Portland, OR, 97229 (US); CANHAM, Rick, West Richland, WA, 99353 (US); BUDDRIUS, Eric W., Hillsboro, OR, 97123 (US); SMALLEY, Jeffory L., East Olympia, WA, 98540 (US); BEATTY, John, Chandler, AZ, 85226 (US); ARIK, Kenan, Hillsboro, OR, 97124 (US); PRABHUGOUD, Mohanraj, Hillsboro, OR, 97124 (US); WHEELER, Kirk, Mesa, AZ, 85205 (US); FERGUSON, Shelby, El Dorado Hills, CA, 95762 (US); CONTRERAS PEREZ, Jorge, 44160 Guadalajara, MX (MX); NEUMANN, Daniel, Tualatin, OR, 97062 (US); BORBOA LIZARRAGA, Ernesto, 45019 Zapopan, MX (MX)
(74) Representative: Maiwald GmbH

(57) **Abstract**

Systems, apparatus, articles of manufacture, and methods are disclosed for supports for internal hardware of electronic devices. An example support includes an integrated circuit (IC) carrier that includes a plurality of walls, supports carried by the walls to support an IC from below the IC, and a retention clip to secure the IC.

## Description

### FIELD OF THE DISCLOSURE

This disclosure relates generally to electronic devices and, more particularly, to supports for internal hardware of electronic devices.

### BACKGROUND

Electronic devices include different supports for different internal hardware at different life steps. For example, a central processing unit (CPU) may be supported by a CPU carrier during the manufacturing process. The CPU carrier carries the CPU as the CPU is moved from a shipping tray to a land grid array (LGA) socket during assembly of an electronic device. CPUs also may be supported by a CPU retention mechanism to secure the CPU to a printed circuit board (PCB). PCBs themselves include structural support under the PCB to buttress the load carried by the PCB.

### BRIEF DESCRIPTION OF THE DRAWINGS

FIG. 1 is a perspective view of an example carrier for an integrated circuit (IC) ("IC carrier") such as a CPU.
FIG. 2 is an enlarged exploded view of an example removal pin and IC carrier.
FIG. 3A and FIG. 3B are schematic illustrations showing example operation of the removal pin to remove an IC from the IC carrier.
FIG. 4 is an exploded view of an example IC retention mechanism with an example double gear transmission assembly.
FIG. 5 is an isolated view of the IC retention mechanism of FIG. 4.
FIG. 6A is an enlarged top view of the double gear transmission assembly of FIG. 4.
FIG. 6B is an enlarged perspective view of the double gear transmission assembly of FIG. 4.
FIG. 6C is an enlarged side view of the double gear transmission assembly of FIG. 4.
FIG. 6D is an enlarged exploded view of the double gear transmission assembly of FIG. 4.
FIG. 7 is an exploded and partially assembled view of the IC retention mechanism of FIG. 4.
FIG. 8 is a top perspective view of the IC retention mechanism of FIG. 4.
FIG. 9 is a bottom perspective view of the IC retention mechanism of FIG. 4.
FIG. 10 is a top perspective view of the IC retention mechanism of FIG. 4 with an example assembly tool.
FIG. 11 is a schematic illustration of operation of retention mechanisms disclosed herein.
FIG. 12 is a bottom perspective of another example IC retention mechanism including an example gear/sprocket transmission assembly.
FIG. 13A is an enlarged top view of the gear/sprocket transmission assembly of FIG. 12.
FIG. 13B is an enlarged perspective view of the gear/sprocket transmission assembly of FIG. 12.
FIG. 13C is an enlarged side view of the gear/sprocket transmission assembly of FIG. 12.
FIG. 13D is an enlarged exploded view of the gear/sprocket transmission assembly of FIG. 12.
FIG. 14 is a side view of the gear/sprocket transmission assembly of FIG. 12.
FIG. 15 is a top perspective view of an example PCB support.
FIG. 16 is an enlarged view of a portion of an example wire of the PCB support of FIG. 15.

In general, the same reference numbers will be used throughout the drawing(s) and accompanying written description to refer to the same or like parts. The figures are not necessarily to scale.

### DETAILED DESCRIPTION

A Package-Heatsink Module (PHM) is a sub-assembly used to load integrated circuits (IC) such as central processing units (CPUs), graphic processing units (GPUs), microprocessors, and/or other processor circuitry onto land grid array (LGA) sockets. One of the parts within that sub-assembly is the IC carrier, which protects the IC during shipping. Functions of the IC carrier include safely moving the IC from a shipping tray to the socket (e.g., an LGA socket) during assembly of the electronic device and ensuring the correct product is installed in the correct orientation. IC, socket, and loading mechanism designs place design constraints on the IC carrier. Additionally, in some examples, it is desirable to have carriers pre-attached to the IC in the shipping trays so that customers are relieved of the process of assembling ICs and IC carriers and controlling IC carrier inventory. Though examples disclosed herein are described with an IC, other components to be coupled to a printed circuit board (PCB) or other substrate via a socket (e.g., an LGA socket) may also be coupled to the example IC carriers disclosed herein.

Also disclosed herein are example IC retention mechanisms. A IC retention mechanism retains an IC (or other device as noted above) in a socket assembly. IC retention mechanism design can be challenging due to space limitations within a Keep-Out Zone associated with the socket/connector. The Keep-Out Zone is an area defined adjacent the socket/connector for the IC to prevent component placement or routing on the PCB surface or through PCB layers to prevent interference. In addition, there is a growing need to increase mechanical loads to compress the IC over sockets, especially on large form factor packages. In other words, although the mechanical load requirements and the number of IC contacts are increasing as electronic devices advance and become more capable, the physical areas to allow implementation of IC retention mechanisms remain restrictive. The example IC retention mechanisms disclosed herein enable robust designs that can be assembled and operated within this restrictive physical area.

In addition, the pins of ICs are very small, thin, fragile, and numerous. Example IC retention mechanisms disclosed herein enable high precision insertion to control the IC angle during insertion and ensure that the IC does not tilt during assembly into the socket.

Example PCB supports also are disclosed herein. Examples disclosed herein integrate torsion loading mechanisms such as, for example, torsion wires or torsion springs on one side (e.g., the bottom side) of a PCB. Prior solutions use load springs that are on the topside of the PCB. As CPU package size increases, loading to enable thermal interface material also grows. As the load grows, typical coil springs grow in diameter to scale with the load increases. In space constrained environments such as the housing of an electronic device (e.g., a personal computer (PC), a laptop, a mobile device such as a phone, a tablet, etc.), there is little room to scale the diameter of coil springs with other electronic components including thermal components competing for space without reconfiguring the PCB and reducing the footprint of the pin layout pattern. Example PCB supports disclosed herein increase the load that the PCB can support. For example, PCB supports disclosed herein include a torsion wire, which has much improved load capability within a compact geometry. Example PCB supports disclosed herein increase the mechanical load of thermal interfaces that the PCB can support, which can increase the thermal capability (i.e., cooling capability) of the electronic device in which the PCB supports are included.

Example IC carriers, example IC retention mechanisms, and example PCB supports disclosed herein may be included individually or in any combination in different electronic devices. For example, an example electronic device may include one or more of (a) one or more example IC carrier(s) disclosed herein, (b) one or more example IC retention mechanisms disclosed herein, and/or (c) one or more example PCB supports disclosed herein.

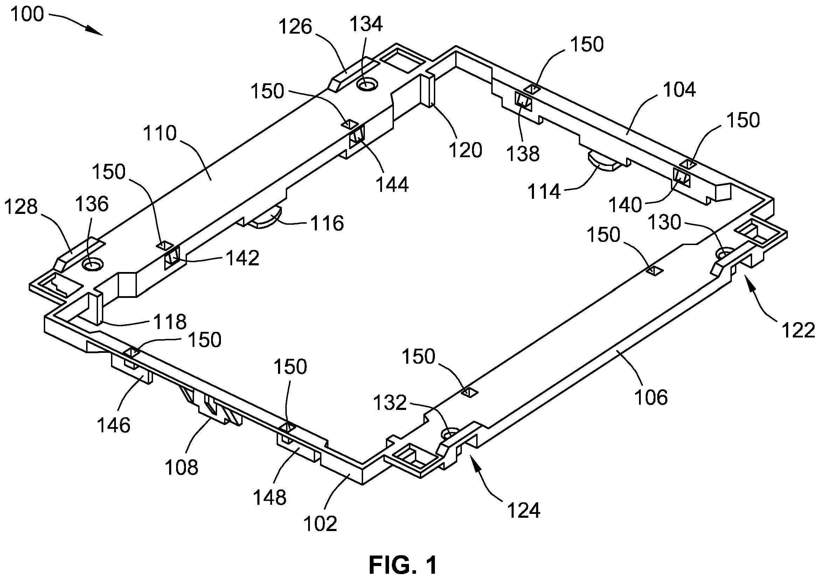

FIG. 1 is a perspective view of an example IC carrier 100 constructed in accordance with teaching of this disclosure. The IC carrier 100 includes an example frame 102. The frame 102 includes an example first wall 104, an example second wall 106, an example third wall 108, and an example fourth wall 110. The first wall 104 is coupled to the second wall 106 at one end and to the fourth wall 110 at the other end. The second wall 106 is coupled to the first wall 104 at one end and to the third wall 108 at the other end. The third wall 108 is coupled to the second wall 106at one end and to the fourth wall 110 at the other end. The fourth wall 110 is coupled to the first wall 104 at one end and to the third wall 108 at the other end.

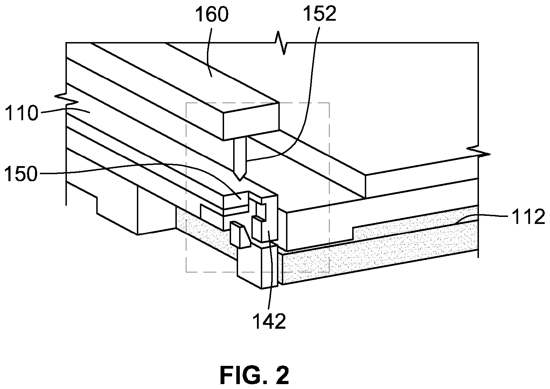

The frame 102 includes a plurality of supports to carry an example IC 112 such as, for example, a IC 112 (FIG. 2). For example, the frame 102 also includes an example first support 114 coupled to the first wall 104. The frame 102 includes an example second support coupled to the third wall 108. In some examples, the second support is opposite the first support 114. In addition, the frame includes an example third support coupled to the second wall 106 and an example fourth support 116 coupled to the fourth wall 110. In some examples, the third support is opposite the fourth support 116. In some examples, the first support 114 and second support may be offset and not positioned directly opposite each other. Similarly, in some examples, the third support and fourth support 116 may be offset and not positioned directly opposite each other. In some examples, the first support 114 and second support are coplanar. In some examples, the third support and fourth support 116 are coplanar. In some examples, all of the first support 114, the second support, the third support, and the fourth support 116 are coplanar. In some examples, there are only two supports (e.g., the first support 114 and the third support; or the second support and the fourth support 116). In other examples, there are three supports or more than four supports. In the illustrated example, the first support 114, the second support, the third support, and the fourth support 116 are located at or near respective lower ends of the first wall 104, the second wall 106, the third wall 108, and the fourth wall 110.

The IC 1121C 112 can be inserted into the IC carrier 100 from, for example, a top side of the carrier 100 and supported by the first support 114, the second support, the third support, and the fourth support 116. In prior designs, a carrier would be pressed down onto an IC (e.g., inserted from below the carrier). Employing topside insertion of an IC into the carrier allows tooling in factories to automate the installation of the IC into the IC carrier. Utilization of automation and machines to install the IC into the IC carrier, eliminates ergonomic restrictions that are needed to press clips or carriers onto an IC from above.

Supporting the IC 112 on the IC carrier 100 from below also enables thinner IC support features (e.g., the first support 114, the second support, the third support, and the fourth support 116) than in prior approaches. In some examples, the thinner IC supports are about 20% thinner than prior approaches. The thinner supports disclosed herein can more easily fit in a smaller space between the IC 112 and a socket than in prior approaches. The thinner IC support features also allows for a thinner socket. The thinner the socket allows for shorter contacts and improves signal integrity. The shorter the contact, the shorter the distance a signal travels and the lower chance for signal degradation, which improves signal integrity.

A fixed support such as, for example, the first support 114, the second support, the third support, and/or the fourth support 116, is stronger than a flexible clip that would be manipulated by a human, as in the prior approaches. In addition, there is a greater degree of freedom on where the first support 114, the second support, the third support, and/or the fourth support 116 can be located because the first support 114, the second support, the third support, and/or the fourth support 116 are not positioned to be manipulated by a human. The greater degree of flexibility on the support locations allows for more adjustable, adaptive, and/or variety of pin map layouts with higher input/output (I/O) counts and adds room to strengthen the socket. In prior IC carrier designs used with short sockets, IC clips were positioned in the corners to be manipulated by a human, which meant that the socket needed cutout openings in the corners to provide clearance for the clips. Removal of the clips away from the socket corners, removes the need for cutout openings on the socket. Without the cutout openings, there is more material in the corners of the socket. As such, there can be taller datum walls, and a stronger or more stiffened socket. A datum wall is an alignment feature on the socket that centers the IC in the socket.

Additionally, the IC carrier 100 has a thinner overall height, which can fit in a Joint Electron Device Engineering Council (JEDEC) shipping tray. In some examples, the height is about 20% thinner than prior approaches. Prior IC carrier designs could not fit in a JEDEC shipping tray.

The IC carrier 100 also includes socket keys to mate with an LGA socket. In other words, the socket keys mate with complementary receptacles on the LGA socket. In the illustrated example, the fourth wall 110 includes an example first socket key 118 and an example second socket key 120. In some examples, there is only one socket key. In some examples, the second wall 106, opposite the fourth wall 110 also includes one or more socket keys. In some examples, the one or more socket keys on the second wall 106 are aligned opposite the first socket key 118 and the second socket key 120 of the fourth wall 110. In some examples, there are other number of socket keys such as three, five, etc. In some examples, one or more the socket keys or additional socket keys are positioned on the first wall 104 and/or the third wall 108.

The IC carrier 100 also includes thermal solution attachment clips to couple the IC carrier 100 with a thermal solution such as, for example, a heat sink. In the illustrated example, the second wall 106 includes an example first thermal solution attachment clip 122 and an example second thermal solution attachment clip 122. The fourth wall 110 includes an example third thermal solution attachment clip 126 and an example fourth thermal solution attachment clip 128. In some examples, there is only one thermal solution attachment clip. In some examples, there is only one thermal solution attachment clip per wall. In some examples, the first thermal solution attachment clip 122 and the second thermal solution attachment clip 124 on the second wall 106 are aligned opposite the third thermal solution attachment clip 126 and the fourth thermal solution attachment clip 128 of the fourth wall 110. In some examples, there are other number of thermal solution attachment clips such as three, five, etc. In some examples, one or more the thermal solution attachment clips or additional thermal solution attachment clips are positioned on the first wall 104 and/or the third wall 108.

The IC carrier 100 also includes alignment holes to align and couple the IC 112 with the LGA socket. In the illustrated example, the second wall 106 includes an example first alignment hole 130 and an example second alignment hole 132, and the fourth wall 110 includes an example third alignment hole 134 and an example fourth alignment hole 136. In some examples, there is only one alignment hole. In some examples, there is only one alignment hole per wall. In some examples, the first alignment hole clip 130 and the second alignment hole 132 on the second wall 106 are aligned opposite the third alignment hole 134 and the fourth alignment hole 136 of the fourth wall 110. In some examples, there are other number of alignment holes such as three, five, etc. In some examples, one or more the alignment holes or additional alignment holes are positioned on the first wall 104 and/or the third wall 108.

The IC 112 is held in the IC carrier 100 to secure the IC 112 and prevent damage to the CPU if, for example, the IC carrier 100 is turned upside down. In some examples, one or more retention clips are used to secure the IC 112 in the IC carrier 100. In the illustrated example, the first wall 104 includes an example first retention clip 138 and an example second retention clip 140. The fourth wall 110 includes an example third retention clip 142 and an example fourth retention clip 144. The third wall 108 includes an example fifth retention clip 146 and an example sixth retention clip 148. The second wall 106 includes example seventh and eight retention clips. In some examples, there may be other numbers of retention clips per wall (e.g., one, three, etc.). In some examples, one or more of the first wall 104, the second wall 106, the third wall 108, and/or the fourth wall 110 may have a different number of retention clips (e.g., zero, one, two, three, etc.) than another one of the first wall 104, the second wall 106, the third wall 108, and/or the fourth wall 110.

The carrier 100 includes example apertures 150 in the first wall 104, the second wall 106, the third wall 108, and/or the fourth wall 110 that correspond to respective ones of the first retention clip 138, the second retention clip 140, the third retention clip 142, the fourth retention clip 144, the fifth retention clip 146, the sixth retention clip 148, the seventh retention clip and/or the eighth retention clip. In the illustrated example, respective ones of the apertures 150 are colinear with respective ones of the first retention clip 138, the second retention clip 140, the third retention clip 142, the fourth retention clip 144, the fifth retention clip 146, the sixth retention clip 148, the seventh retention clip and/or the eighth retention clip.

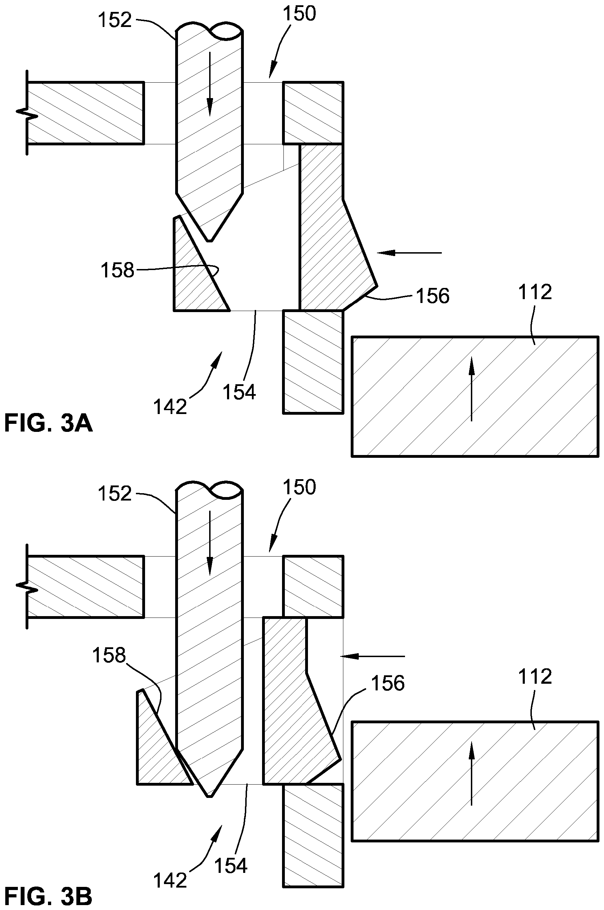

FIG. 2 is an enlarged exploded view of an example removal pin 152 that is used to remove the IC 112 from the IC carrier 100. An IC may be removed from a carrier when, for example, the IC is returned to the manufacturer, and operations are to be performed on the IC without the carrier. FIG. 3A and FIG. 3B are schematic illustrations showing example operation of the removal pin 152. The operation of the removal pin 152 can be either a manual process and/or an automated process. Removal of the IC 112 from the IC carrier 100 is described herein with respect to the third retention clip 142 on the fourth wall 110, but the same description applies across the retention clips disclosed herein. Thus, further details of the third retention clip 142 shown and described relative to FIGS. 2, 3A, and 3B apply to any of the retention clips disclosed herein.

To remove the IC 112 from the IC carrier 100, the removal pin 152 is inserted into the aperture 150 of the fourth wall 110. The removal pin 152 engages the third retention clip 142. The third retention clip 142 includes an example cavity 154 to receive the removal pin 152. The third retention clip 142 includes an example first surface 156 that is engageable with the electronic component (e.g., the IC 112). The third retention clip 142 includes an example second surface 158 that is engageable with the removal pin 152. In some examples, the second surface 158 includes a cam and/or ramp. The third retention clip 142 is rotatable. As the removal pin 152 engages the second surface 158 and is pressed further into the aperture 150 and the cavity 154, the third retention clip 142 rotates due to the engagement of the pin 152 and the second surface 158. In some examples, the third retention clip 142 slides. In the illustrated example, the third retention clip 142 rotates in a clockwise direction, which retracts the first surface 156 into the fourth wall 110. The retracted first surface 156 clears the IC 112. This allows the IC 112 to be removed from the IC carrier 110.

In some examples the removal pin 152 is coupled to an example elongated bar 160 (FIG. 2). The elongated bar 160 is coupled to a second removal pin. Thus, the elongated bar 160 with two removal pins can simultaneously retract, for example, the third retention clip 142 and the fourth retention clip 144 in response to insertion (e.g., simultaneously insertion) of the two removal pins into the corresponding apertures on the fourth wall 110. The same process can be repeated on any of the walls. In addition, in some examples, there are multiple elongated bars 160 with removal pins to retract corresponding ones of the retention clips on the IC carrier 100.

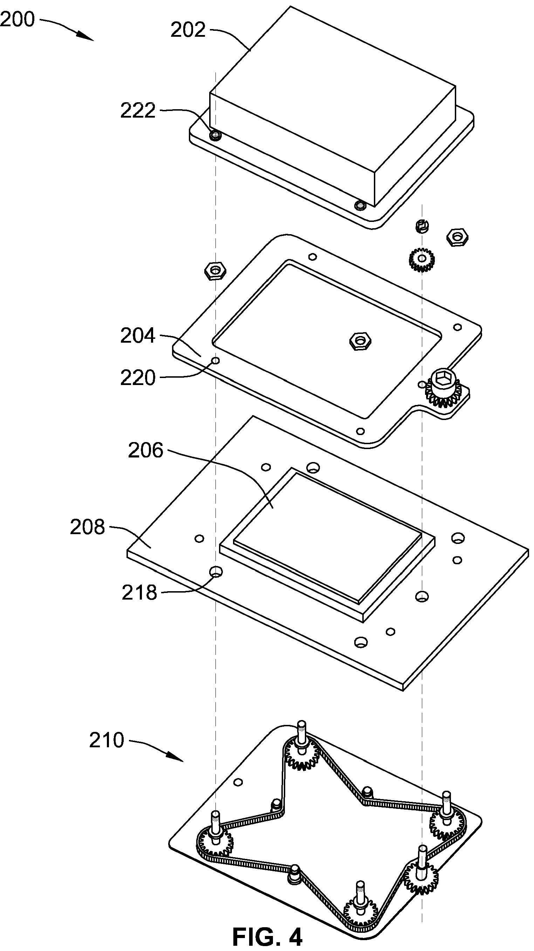

FIG. 4-14 illustrate example IC retention mechanisms or simply retention mechanisms. FIG. 4 is an exploded view of an example system 200 for retaining an IC. The system 200 includes an example component such as a thermal solution 202, an example bolster plate 204, an example electronics package 206, an example PCB 208, and an example retention mechanism 210. In some examples, the thermal solution 202 is a heat sink. In some examples, the package 206 is an IC such as, for example, the IC 112. In some examples, the retention mechanism 210 is a torsional force transmission system. In some examples, the thermal solution 202 is on a first side of the PCB 208, and the retention mechanism 210 is on a second side of the PCB 208. In the illustrated example, the retention mechanism 210 is on the bottom side of the PCB 208. The retention mechanism 210 under the PCB 208, enables use of different configurations of retention mechanisms such as torsional force transmission systems where the elements of such systems fit within the gap between a server chassis sled of the electronic device in which the system 200 is position and a backplate of the retention mechanism 210. In some examples, the gap is about 5 millimeters (mm). In some examples, the height of the elements of the retention mechanism is about 5mm.

The retention mechanism 210 pulls the thermal solution 202 toward the PCB 208, which retains the package 206 between the thermal solution 202 and the PCB 208. A functioning principle of the system 200 is that the package-thermal solution loading takes advantage of a stiff, flat bottom surface of the thermal solution 202 to directly compress the upper surface of the package 206.

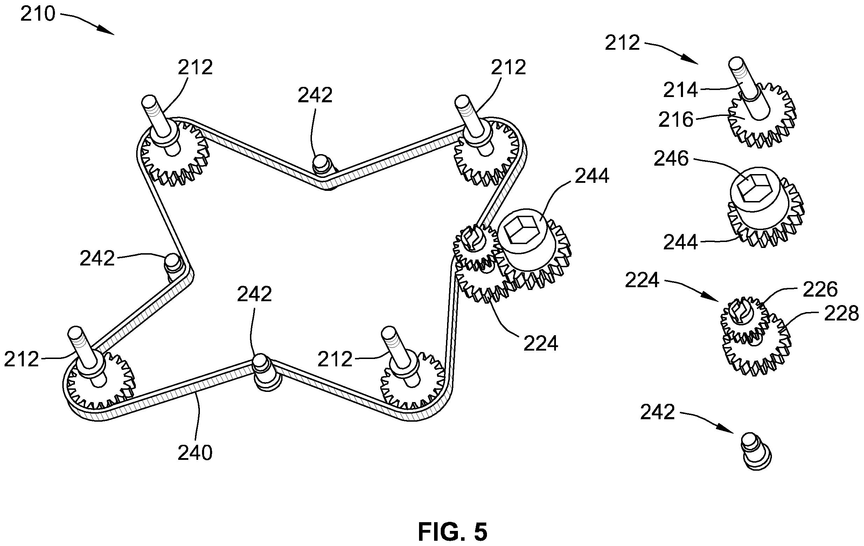

FIG. 5 is an isolated view of the retention mechanism 210 of FIG. 4. The retention mechanism 210 includes a plurality of example screw assemblies 212. Respective ones of the screw assemblies 212 include an example screw 214 and an example gear 216. The screw assemblies 212 releasably couple the retention mechanism 210 with the thermal solution 202. For example, the screws 214 extend through example apertures 218 in the PCB 208, through example apertures 220 in the bolster plate 204, and through example apertures 222 in the thermal solution 202. In some examples, the apertures 222 of the thermal solution 202 are threaded grommets that engage with threads on the screws 214. In some examples, there are four sets of each of the screw assemblies 212, the screws 214, the gears 216, the apertures 218 in the PCB 208, the apertures 220 in the bolster plate 204, and the apertures 222 in the thermal solution 202. Other examples may include other numbers of sets of these components such as, for example, two, three, five, etc.

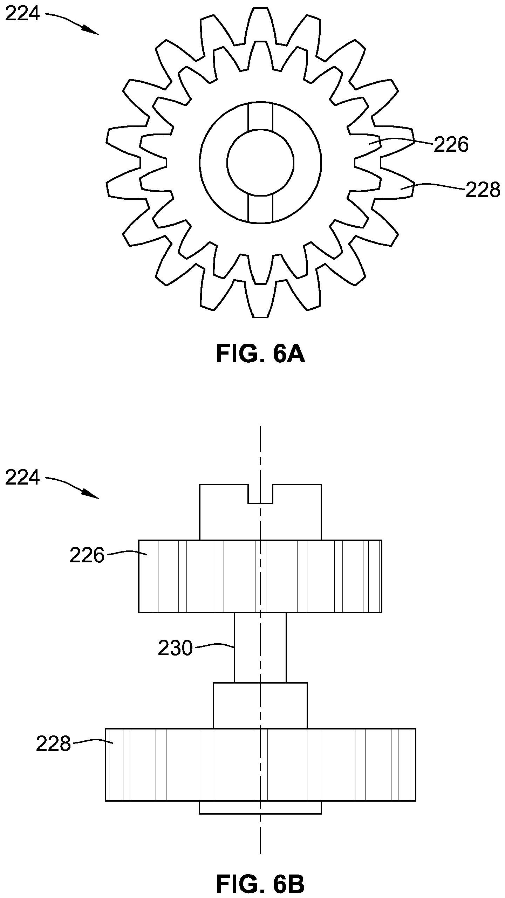

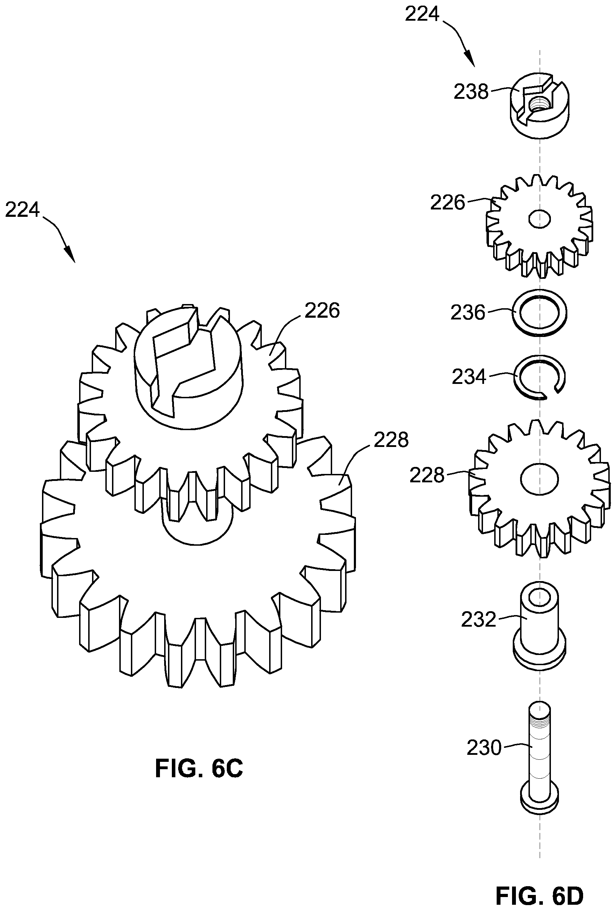

The retention mechanism 210 also includes an example double gear transmission assembly (also referred to herein as a double gear assembly) 224. The double gear assembly 224 includes an example first gear 226 and an example second gear 228. FIG. 6A is a top view of the double gear assembly 224. FIG. 6B is a perspective view of the double gear assembly 224. FIG. 6C is a side view of the double gear assembly 224. FIG. 6D is an exploded view of the double gear assembly 224. The double gear assembly 224 also includes an example drive shaft 230 coupled between the first gear 226 and the second gear 228. In some examples, the drive shaft 230 extends through an example rivet nut 232, an example retainer 234, an example washer 236, and an example slotted round nut 238. In other examples, fewer, additional, and/or alternative fasteners may be used to form the double gear transmission assembly 224.

The retention mechanism 210 includes an example timing belt 240. In some examples, the timing belt 240 includes silicone with Kevlar reinforcement to provide tension, shock resistance, and capacity to withstand high temperatures. In other examples, other materials may additionally and/or alternatively be used for providing tension, shock resistance, and/or capacity to withstand high temperatures. Similar materials may be used for any of the gears disclosed herein.

The timing belt 240 is coupled between the screw assemblies 212 and the second gear 228 of the double gear assembly 224. The timing belt 240 has a first side, a second side, and teeth on the first side and the second side to engage the plurality of screw assemblies 212 and the double gear assembly 224. In some examples, the teeth on the first side of the timing belt 240 engage the double gear assembly 224, and the teeth on the second side of the timing belt 240 engage the plurality of screw assemblies 212.

The retention mechanism 210 includes a plurality of example pulleys 242. In some examples, the pulleys 242 are tensor pulleys. In some examples, the pulleys 242 engage the timing belt 240 between screw assemblies 212. In the illustrated example there are three pulleys 242. Other examples may include additional or fewer pulleys 242. In some examples, between the two screw assemblies 212 where the double gear assembly 224 is positioned, there is no pulley 242.

The retention mechanism 210 includes a main transmission gear (also referred to herein as a main gear) 244. The main gear 244 is coupled to the first gear 226 of the double gear assembly 224. The main gear 244 includes an example tool bit socket 246 via which a tool may be used to turn the main gear 244. In this disclosure "main" is a naming convention to differentiate the gears, but it is not intended to imply any ordering, preference or the like. The main gear 244 is manipulated by a user to operate the retention mechanism 210.

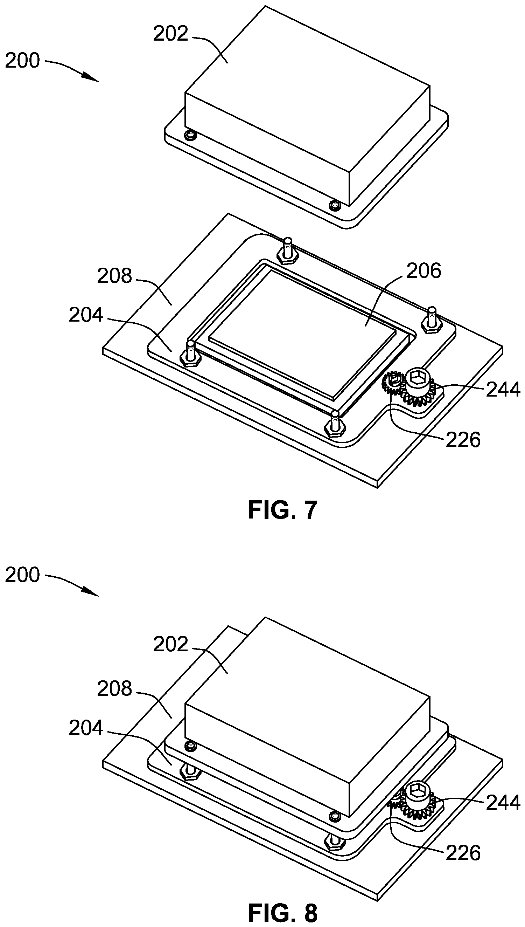

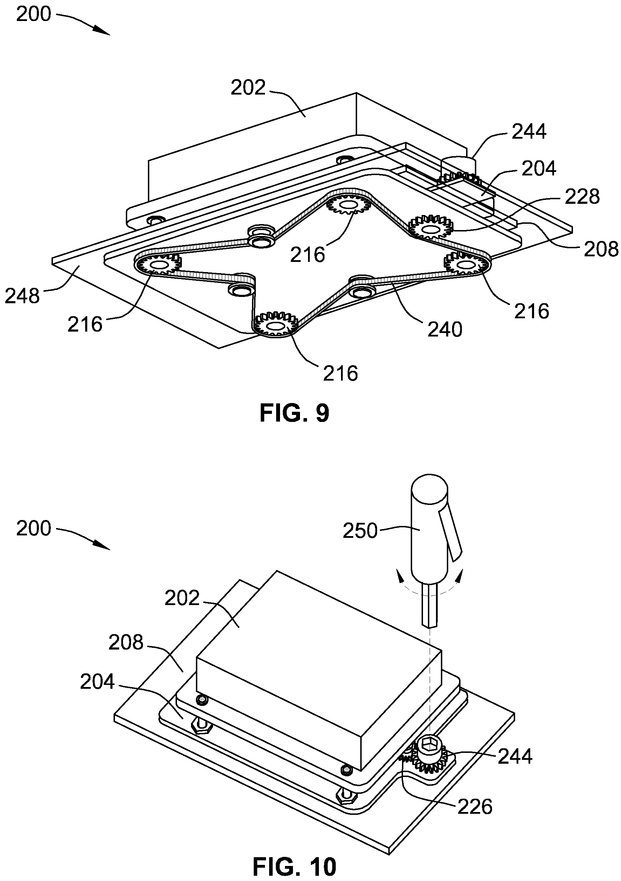

FIG. 7 is a partially assembled view of the system 200. FIG. 8 is a top perspective view of the assembled system 200. FIG. 9 is a bottom perspective view of the assembled system 200. As shown in FIG. 9, the system 200 includes an example back plate 248. The gears 216 of the plurality of screw assemblies 212 and the second gear 228 of the double gear assembly 224 are positioned on a first side (e.g., lower or bottom side) of the back plate 248. The PCB 208, the first gear 226 of the double gear assembly 224, and the main gear 244 are positioned on a second side (e.g., upper or top side) of the back plate 248. In this example, the drive shaft 230 extends through the back plate 248 between the first gear 226 and the second gear 228.

FIG. 10 is a top perspective view of the assembled system 200 and example assembly tool 250. The assembly tool 250 engages with the tool bit socket 246 of the main gear 244. The user manipulates the assembly tool 250 to turn the main gear 244. In the illustrated example, the assembly tool 250 is a screwdriver. In other examples, other assembly tools (e.g., hex wrenches, etc.) may be used. In some examples, the user gently pressed the thermal solution 202 while rotating the assembly tool 250 to initiate thread engagement between the thermal solution 202 and the threads on the screws 214.

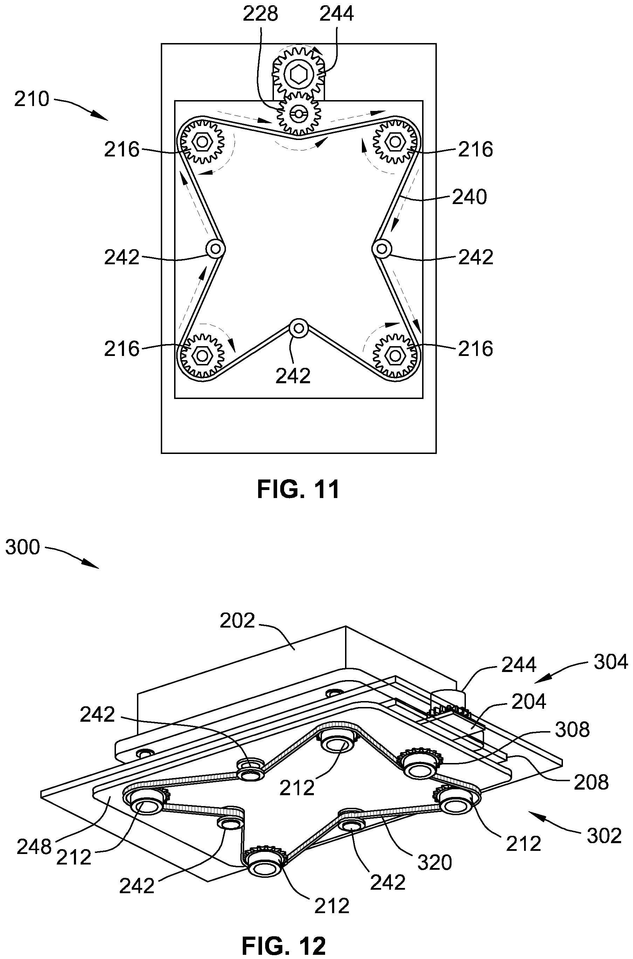

FIG. 11 is a schematic illustration showing an example operation of the retention mechanism 210. If the user rotates the main gear 244 to the right or clockwise, torque is applied to the double gear assembly 224 and the lower or second gear 228 of the double gear assembly 224 rotates to the left or counter-clockwise. The second gear 228 moves the timing belt 240 in a clockwise direction. The timing belt 240 rotates each of the gears 216 of the screw assemblies 212 to the right or in a clockwise direction.

Rotation of the screw assemblies 212 causes the screws 214 to engage with the thermal solution 202 (e.g., to engage with the apertures 222 of the thermal solution 202 that may be threaded grommets). As the screws 214 engage the thermal solution 202, the retention mechanism 210 pulls the thermal solution 202 toward the PCB 208. The retention mechanism 210 applies this force to the corners of the thermal solution 202 evenly and simultaneously. The force applied to the thermal solution 202 causes the thermal solution to compress the package 206. Compression of the package 206 (e.g., the IC 112) causes the package 206 to engage into the pins of the socket (e.g., an LGA socket).

The gears of the retention mechanism 210 are assembled to the back plate 248 located below the PCB 208, which allows torsional force transmission to all the screws 214 at the same time by turning of only one main transmission element (e.g., the main gear 244) using the assembly tool 250. The turning of the screws 214 pulls the screws toward the PCB 208 and then translates the rotational form from the main gear 244 into a downward force to apply a load to the package 206 in a controlled way as disclosed above. In some examples, the torque applied to the main transmission element (e.g., the main gear 244) may be based on specific load requirements of the thermal solution 202 and package 206.

FIG. 12 is a bottom perspective of another example system 300 for retaining an IC a package such as, for example, a CPU to a PCB and/or a socket. The example system 300 is similar to the system 200 disclosed above. As such, descriptions of similar elements will not be repeated herein. Instead, the interested reader is referred to the above for a complete discussion of the similar elements. Like reference numbers are used for like elements to facilitate that referral. However, the system 300 includes an example gear/sprocket transmission assembly instead of the double gear transmission assembly. In some examples, a sprocket in place of a gear improves interaction between transmission elements, which is useful in situations with higher loads.

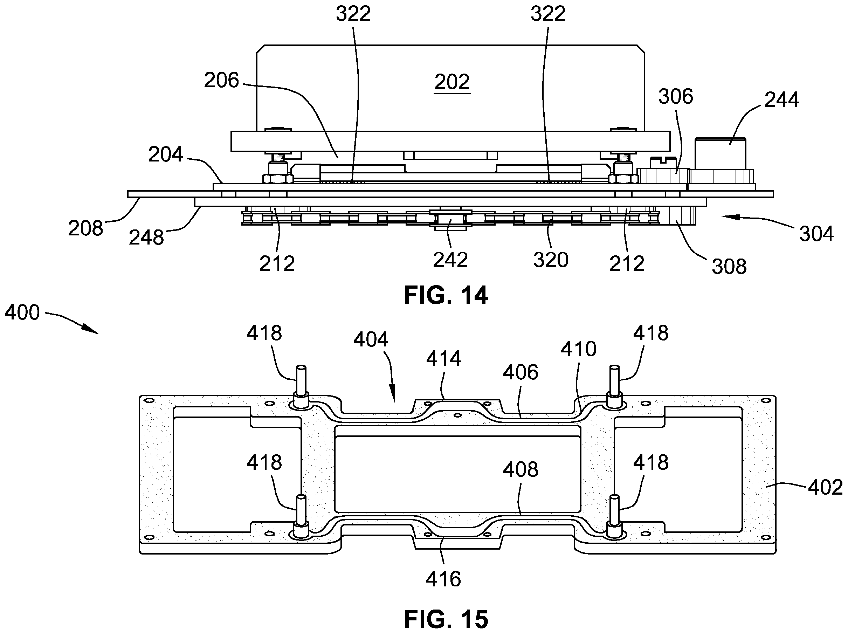

The example system 200 includes an example component such as the thermal solution 202 (e.g., a heat sink), the bolster plate 204 (FIG. 14), the electronic package 206 (e.g., An IC) (FIG. 14), the PCB 208, and an example retention mechanism 302. The retention mechanism 302 is a torsional force transmission system. As with the system 200, in the illustrated example system 300, the thermal solution 202 is on a first side of the PCB 208, and the retention mechanism 302 is on a second side of the PCB 208. In the illustrated example, the retention mechanism 302 is on the bottom side of the PCB 208.

The retention mechanism 302 includes the plurality of example screw assemblies 212 that releasably couple the retention mechanism 302 with the thermal solution 202 in a manner similar to that disclosed above with the system 200.

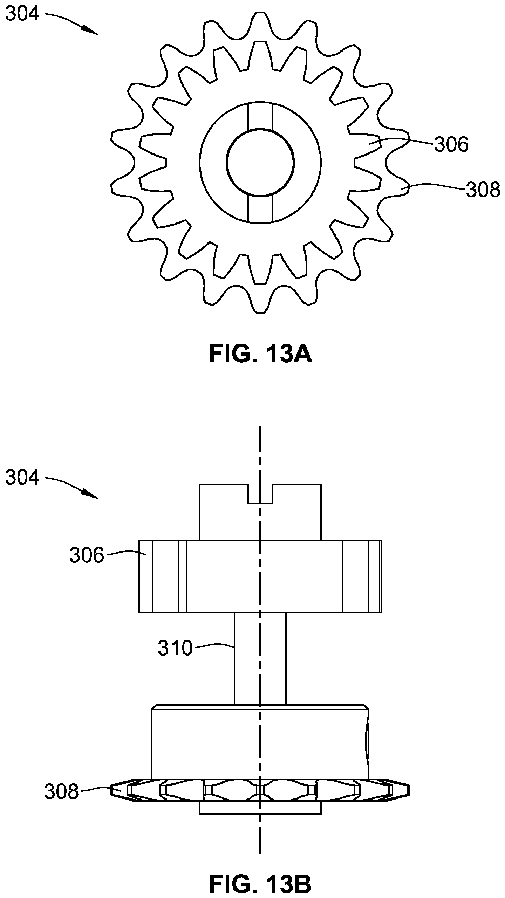

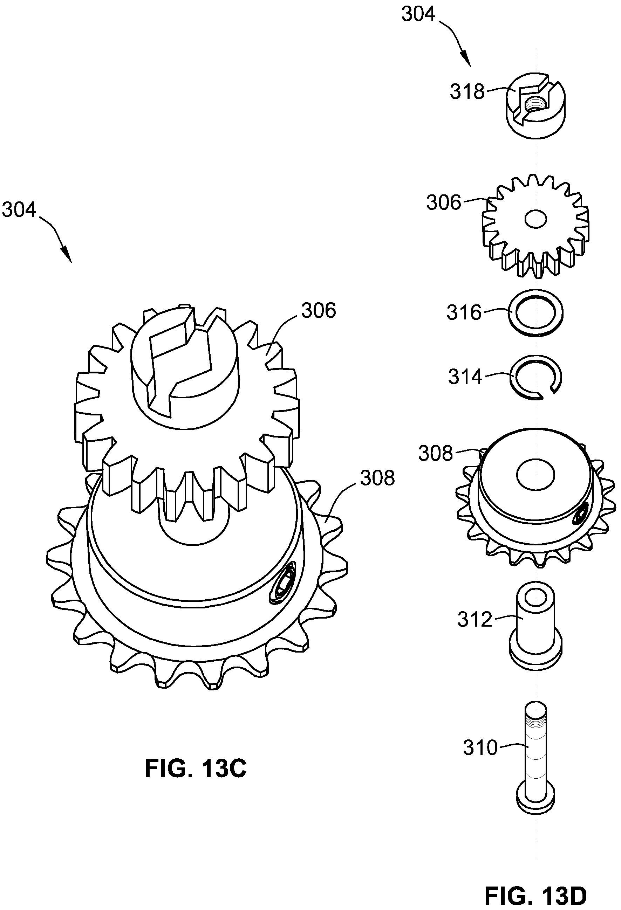

The retention mechanism 302 also includes an example gear-sprocket transmission assembly 304. The gear-sprocket transmission assembly 304 includes an example gear 306 and an example sprocket 308. FIG. 13A is a top view of the gear-sprocket transmission assembly 304. FIG. 13B is a perspective view of the gear-sprocket transmission assembly 304. FIG. 13C is a side view of the gear-sprocket transmission assembly 304. FIG. 13D is an exploded view of the gear-sprocket transmission assembly 304. The gear-sprocket transmission assembly 304 also includes an example drive shaft 310 coupled between the gear 306 and the sprocket 308. In some examples, the drive shaft 310 extends through an example rivet nut 312, an example retainer 314, an example washer 316, and an example slotted nut 318. In other examples, fewer, additional, and/or alternative fasteners and/or other components may be used to form the gear-sprocket transmission assembly 304.

The retention mechanism 302 of this example includes an example transmission chain 320. In some examples, the transmission chain 320 includes a lightweight material. In some examples, the transmission chain 320 includes a quiet material. In some examples, the transmission chain 320 includes a reinforced material. In some examples, the transmission chain 320 includes a non-conductive material. In some examples, the transmission chain 320 includes a plastic material such as, for example, acetal plastic. In other examples, other materials may additionally and/or alternatively be used for providing tension, shock resistance, and capacity to withstand high temperatures. Similar materials may be used for any of the gears disclosed herein.

The transmission chain 320 is coupled between the screw assemblies 212 and the sprocket 308 of the gear-sprocket transmission assembly 304. The transmission chain 320 includes apertures between links to engage the plurality of screw assemblies 212 and the sprocket 308. The transmission chain 320 has a first side and a second side. Respective ones of the screw assemblies 212 engage the first side of the transmission chain 320. The sprocket 308 of the gear-sprocket transmission assembly 304 engages the second side of the transmission chain 320 between two of the screw assemblies 212.

The retention mechanism 302 includes a plurality of the pulleys 242 as disclosed above in the description of the system 200. The retention mechanism 302 also includes the main gear 244. The main gear 244 is coupled to the gear 306 of the gear-sprocket transmission assembly 304. The main gear 244 includes the tool bit socket 246 via which a tool (e.g., the assembly tool 250) may be used to turn the main gear 244, as disclosed above.

FIG. 14 is a side view of the system 300 of FIG. 12. The system 300 includes the back plate 248. The gears 216 of the plurality of screw assemblies 212 and the sprocket 308 of the gear-sprocket transmission assembly 304 are positioned on a first side (e.g., lower or bottom side) of the back plate 248. The PCB 208, the gear 306 of the gear-sprocket transmission assembly 304, and the main gear 244 are positioned on a second side (e.g., upper or top side) of the back plate 248. In this example, the drive shaft 310 extends through the back plate 248 between the sprocket 308 and the gear 306 of the gear-sprocket transmission assembly 304. FIG. 14 also illustrated example socket pins 322 via which the package 206 is coupled to an LGA socket. The retention mechanism 302 operates in a manner similar to the retention mechanism 210 as disclosed in FIG. 11.

FIG. 15 is a top perspective view of an example PCB support 400. The PCB support 400 may be used to support a PCB such as, for example the PCB 208, and an electronic component on the PCB 208. In some examples, the electronic component is the thermal solution 202. The PCB support 400 can be positioned beneath the PCB 208 to support the thermal solution 202 or other loads above the PCB 208. Thus, the topside of the PCB 208 can have a small amount of (e.g., minimal) mechanical hardware as load support structure. In some examples, the PCB support 400 is mounted to a cold plate such as, for example, a cold plate made of copper.

The PCB support 400 includes an example frame 402 and an example torsion loading mechanism 404. In some examples, the frame 402 includes steel, aluminum, and/or ceramic. The torsion loading mechanism 404 includes a first example torsion wire 406 and a second example torsion wire 408. In some examples, the first torsion wire 406 and the second torsion wire 408 are contiguous. In some examples, torsion loading mechanism 404 includes a different number of torsion wires such as, for example, one, three, etc. In some examples, one or more of the first torsion wire 406 and/or the second torsion wire 408 have a diameter of about 3mm (+/- 20%). In some examples, the frame 402 includes a first example channel 410 in which the first torsion wire 406 is at least partially embedded and a second example channel 412 in which the second torsion wire 408 is at least partially embedded or housed. In some examples, the first channel410 and the second channel412 are contiguous. In some examples, the first torsion wire 406 and/or the second torsion wire 408 are adjacent and/or on the frame 402.

In some examples, the first torsion wire 406 includes an example first allowance section 414 and the second torsion wire 408 includes an example second allowance section 416. The first allowance section 414 and the second allowance section 416 allow for movement of the respective first torsion wire 406 and/or second torsion wire 408 based on spring preload and/or a retention cover. In some examples, one or more of the first channel 410 and/or the second channel 412 form pockets for the respective first torsion wire 406 and the second torsion wire 408. In some examples, if there is no pocket, and the wire (e.g., the first torsion wire 406 and/or the second torsion wire 408) is mounted on the frame 402, a cover may be added to one or more of the first allowance section 414 and/or the second allowance section 416.

The torsion loading mechanism 404 includes a plurality of example load studs 418. In the illustrated example, there are load studs 418 coupled to ends of the first torsion wire 406 and the second torsion wire 408. Thus, in the illustrated example, the plurality of load studs 418 includes a first load stud 418 coupled to a first end of the first torsion wire 406, a second load stud 418 coupled to a second end of the first torsion wire 406, a third load stud 418 coupled to a first end of the second torsion wire 408, and a fourth load stud 418 coupled to a second end of the second torsion wire 408. The load studs 418 extends from the torsion loading mechanism 404 through the PCB 208 to support the package 206 and/or another component (e.g., the thermal solution 202).

When a stack of the thermal solution 202, the electronic package 206, the PCB 208, and the PCB support 400 is assembled, the load studs 418 are actuated, transferring the existing preload in the first torsion wire 406 and the second torsion wire 408 to the thermal solution 202. The transfer of the existing preload of the first torsion wire 406 and the second torsion wire 408 deflects the first torsion wire 406 and the second torsion wire 408 based on their respective spring rates, which absorbs tolerances including manufacturing differences in the connection areas of the thermal solution 202. The preload in the first torsion wire 406 and the second torsion wire 408 reduces the distances the first torsion wire 406 and the second torsion wire 408 deflect to reach the load target for supporting the thermal solution 202.

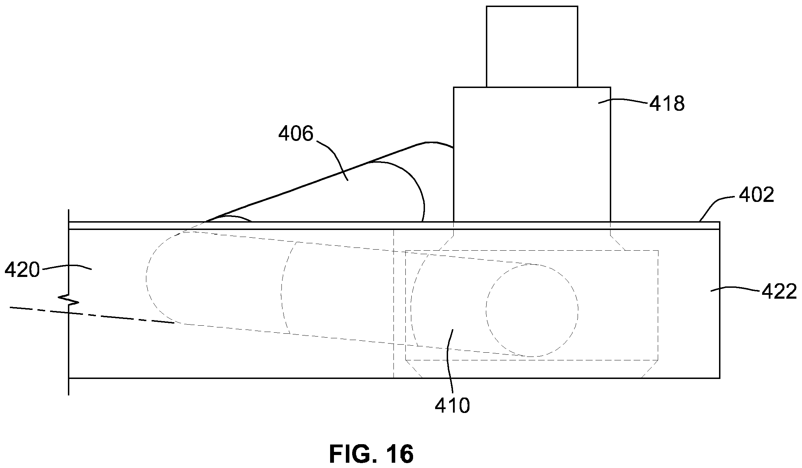

FIG. 16 is an enlarged view of a portion of the first torsion wire 406 and frame 402 of the PCB support 400 of FIG. 15. To maintain a slim form factor in the example in which the torsion wire 406 is embedded in the first channel 410 of the frame 402, the material of the frame 402 is cut at an angle to allow the torsion wire 406 to rotate deeper within the first channel 410. The angle also allows for additional travel to allow more variation in the tolerances of the stack of the thermal component 202, the package 206, the PCB 208, and the PCB support 400. Thus, in some examples, the first channel 410 has a first depth at a first portion 420 of the frame 402 and second depth at a second portion 422 of the frame, the second depth greater than the first depth. The angled configuration of the first channel 410 can also be applied to the second channel412.

From the foregoing, it will be appreciated that example systems, apparatus, articles of manufacture, and methods have been disclosed that provide support for the internal hardware of electronic devices.

There are many advantages of the example IC carriers disclosed herein. For example, customers no longer need to order and manage IC carrier inventory because the ICs may be coupled to the IC carriers. Customers thus do not need to spend resources for assembling the IC carrier onto CPUs, which can reduce throughput time for customers, damage ICs, and result in downtime for incorrect inventory and/or replacing damaged ICs. In addition, the IC carriers disclosed here are not manually installed and, therefore, do not have design features that are limited by ergo requirements. Also, the IC carriers disclosed herein enable greater design flexibility on the IC and the LGA socket.

The IC retention mechanisms disclosed herein enable the retention of Larger and more complex IC designs within the same restrictive physical area. In addition, the IC retention mechanisms disclosed herein enable secure and even retention of ICs into LGA sockets without tilt during insertion. Unlike prior design with separate screws that had to be separately turned, resulting in uneven assembly of the IC into the LGA socket. Tilting an IC could break the fragile pins that connect the IC to the LGA socket. The IC retention mechanisms disclosed herein also enable low load socket technologies and an increase in contacts from and performance of an IC.

PCB supports disclosed herein enable the topside of the PCBs to have minimal mechanical hardware as load support structure. The backside integrated torsion loading mechanism of the PCB support provides a high load capable integrated solution for applying load and support to a package. This allows for faster integration and easier customer adoption, while maintaining a corner package loading strategy that enhances thermal performance and minimizes cost with less top-side load support.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified in the below description.

Systems, apparatus, articles of manufacture, and methods are disclosed for supports for internal hardware of electronic devices. Example 1 includes an integrated circuit (IC) carrier that includes a plurality of walls, supports carried by the walls to support an IC from below the IC, and a retention clip to secure the IC.

Example 2 includes the integrated circuit (IC) carrier of Example 1, wherein the supports are coplanar.

Example 3 includes the integrated circuit (IC) carrier of Example claim 2, the supports include a first support, a second support, a third support, and a fourth support.

Example 4 includes the integrated circuit (IC) carrier of any of Examples 1-3, wherein the IC is a CPU.

Example 5 includes the integrated circuit (IC) carrier of Example claim 4 further including the CPU.

Example 6 includes the integrated circuit (IC) carrier of any of Examples 1-5, wherein at least one of the walls includes a thermal solution attachment clip.

Example 7 includes the integrated circuit (IC) carrier of any of Examples 1-6, wherein at least one of the walls includes a socket key to mate with a land grid array socket.

Example 8 includes the integrated circuit (IC) carrier of Example 7, wherein at least two of the walls include a socket key to mate with a land grid array socket.

Example 9 includes the integrated circuit (IC) carrier of any of Examples 1 -8, wherein at least one of the walls includes a plurality of socket keys to mate with a land grid array socket.

Example 10 includes the integrated circuit (IC) carrier of any of Examples 1-9, wherein the retention clip is carried by a first wall of the plurality of walls, the first wall including an aperture to receive a pin to retract the retention clip.

Example 11 includes the integrated circuit (IC) carrier of Example 10, wherein the retention clip and aperture are colinear on the first wall.

Example 12 includes the integrated circuit (IC) carrier of any of Examples 1-11, wherein the retention clip is rotatable.

Example 13 includes the integrated circuit (IC) carrier of any of Examples 1-12, wherein the retention clip includes a first surface engageable with the IC and a second surface engageable with a pin to retract the retention clip.

Example 14 includes the integrated circuit (IC) carrier of Example 13, wherein the second surface includes a ramp.

Example 15 includes the integrated circuit (IC) carrier of any of Examples 1-14, wherein the plurality of walls include an alignment hole to align the IC carrier with a land grid array socket.

Example 16 includes a system that includes a printed circuit board (PCB); a thermal component on a first side of the PCB; and a gear assembly on a second side of the PCB opposite the first side, the gear assembly to pull the thermal component toward the PCB.

Example 17 includes the system of Example 16, wherein the thermal component is a heat sink.

Example 18 includes the system of any of Examples 16 or 17, further including an integrated circuit between the thermal component and the PCB.

Example 19 includes the system of any of Examples 16-18, wherein the gear assembly includes: a plurality of screw assemblies, respective ones of the screw assemblies including a gear and a screw; a main gear; and a timing belt coupled between the screw assemblies and the main gear.

Example 20 includes the system of Example 19, wherein the gear assembly includes a double gear assembly.

Example 21 includes the system of any of Examples 19 or 20, wherein the main gear includes a tool bit socket.

Example 22 includes the system of any of Examples 19-21, wherein the timing belt has a first side, a second side, teeth on the first side to engage the plurality of screw assemblies, and teeth on the second side to be drawn by the main gear.

Example 23 includes the system of Example 22, wherein the teeth on the first side of the timing belt engage a double gear assembly.

Example 24 includes the system of any of Examples 19-23, wherein the timing belt includes silicone and Kevlar.

Example 25 includes the system of any of Examples 16-24, wherein the gear assembly includes: a plurality of screw assemblies, respective ones of the screw assemblies including a gear and a screw, the screw releasably coupled to the thermal component; a gear-sprocket transmission assembly having a gear and a sprocket; a chain coupled between the plurality of screw assemblies and the sprocket of the gear-sprocket transmission assembly; and a main gear coupled to the gear of the gear-sprocket transmission assembly.

Example 26 includes the system of Example 25, wherein the chain has a first side, a second side, respective ones of the plurality of screw assemblies engage the first side of the chain and the sprocket of the gear-sprocket transmission assembly engages the second side of the chain.

Example 27 includes the system of any of Examples 25 or 26, wherein the screw assemblies include a first screw assembly, a second screw assembly, a third screw assembly, and a fourth screw assembly, the system further including: a first pulley between the first screw assembly and the second screw assembly; a second pulley between the second screw assembly and the third screw assembly; and a third pulley between the third screw assembly and the fourth screw assembly, the first pulley, the second pulley, and third pulley coupled to the chain.

Example 28 includes the system of Example 27, wherein the sprocket is coupled to the chain between the fourth screw assembly and the first screw assembly.

Example 29 includes the system of any of Examples 25-28, wherein the chain includes a non-conductive material.

Example 30 includes the system of any of Examples 25-29, wherein the chain includes acetal plastic.

Example 31 includes the system of any of Examples 16-30, wherein the thermal component has four corners, and the gear assembly applies force to the four corners simultaneously.

Example 32 includes the system of any of Examples 16-31, wherein the thermal component has a plurality of corners, and gear assembly applies force evenly to the plurality of corners.

Example 33 includes a system that includes a printed circuit board (PCB); a component on a first side of the PCB; and a torsion loading mechanism on a second side of the PCB opposite the first side, the torsion loading mechanism to support the component through the PCB, the torsion loading mechanism including a torsion wire.

Example 34 includes the system of Example 33, wherein the torsion loading mechanism includes a frame, the torsion wire coupled to the frame.

Example 35 includes the system of Example 34, wherein the frame includes a channel, the torsion wire housed at least partially in the channel.

Example 36 includes the system of Example 35, wherein the channel is angled.

Example 37 includes the system of any of Examples 35 or 36, wherein the channel has a first depth at a first portion of the frame and second depth at a second portion of the frame, the second depth greater than the first depth.

Example 38 includes the system of any of Examples 34-37, wherein the frame includes one or more of steel, aluminum, or ceramic.

Example 39 includes the system of any of Examples 33-38, wherein the torsion wire is a first torsion wire, the torsion loading mechanism including a second torsion wire.

Example 40 includes the system of any of Examples 33-39, further including a plurality of load studs extending from the torsion loading mechanism through the PCB to support the component.

Example 41 includes the system of Example 40, wherein the torsion wire is a first torsion wire, torsion loading mechanism including a second torsion wire, and the plurality of load studs includes: a first load stud coupled to a first end of the first torsion wire, a second load stud coupled to a second end of the first torsion wire, a third load stud coupled to a first end of the second torsion wire, and a fourth load stud coupled to a second end of the second torsion wire.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A system comprising:
a printed circuit board (PCB);
a thermal component on a first side of the PCB; and
a gear assembly on a second side of the PCB opposite the first side, the gear assembly to pull the thermal component toward the PCB.

2. The system of claim 1, wherein the gear assembly includes:
a plurality of screw assemblies, respective ones of the screw assemblies including a gear and a screw;
a main gear; and
a timing belt coupled between the screw assemblies and the main gear.

3. The system of any preceding claim, wherein the gear assembly includes a double gear assembly.

4. The system of claim 2, wherein the main gear includes a tool bit socket.

5. The system of claim 2, wherein the timing belt has a first side, a second side, teeth on the first side to engage the plurality of screw assemblies, and teeth on the second side to be drawn by the main gear.

6. The system of claim 5, wherein the teeth on the first side of the timing belt engage a double gear assembly.

7. The system of any preceding claim, wherein the gear assembly includes:
a plurality of screw assemblies, respective ones of the screw assemblies including a gear and a screw, the screw releasably coupled to the thermal component;
a gear-sprocket transmission assembly having a gear and a sprocket;
a chain coupled between the plurality of screw assemblies and the sprocket of the gear-sprocket transmission assembly; and
a main gear coupled to the gear of the gear-sprocket transmission assembly.

8. The system of claim 7, wherein the chain has a first side, a second side, respective ones of the plurality of screw assemblies engage the first side of the chain and the sprocket of the gear-sprocket transmission assembly engages the second side of the chain.

9. The system of any of claims 7 or 8, wherein the screw assemblies include a first screw assembly, a second screw assembly, a third screw assembly, and a fourth screw assembly, the system further including:
a first pulley between the first screw assembly and the second screw assembly;
a second pulley between the second screw assembly and the third screw assembly; and
a third pulley between the third screw assembly and the fourth screw assembly, the first pulley, the second pulley, and third pulley coupled to the chain.

10. The system of claim 9, wherein the sprocket is coupled to the chain between the fourth screw assembly and the first screw assembly.

11. The system of any preceding claim, wherein the thermal component has a plurality of corners, and the gear assembly applies force evenly to the plurality of corners.

12. The system of claim 1, further including
a torsion loading mechanism on the second side of the PCB opposite the first side, the torsion loading mechanism to support the thermal component through the PCB, the torsion loading mechanism including a torsion wire.

13. The system of claim 12, wherein the torsion loading mechanism includes a frame, and an angled channel in the frame, the torsion wire at least partially in the channel.

14. The system of claim 13, wherein the channel has a first depth at a first portion of the frame and second depth at a second portion of the frame, the second depth greater than the first depth.

15. The system of any preceding claim further including a carrier that includes:
a plurality of walls;
supports carried by the walls to support the thermal component from below the IC; and
a retention clip to secure the thermal component.
